# EUROPEAN PATENT SPECIFICATION

(11) **EP 3 315 302 B1**
(45) Date of publication and mention of the grant of the patent: **23.02.2022**
(21) Application number: 16814441.8
(22) Date of filing: 23.06.2016
(51) Int. Cl.: B32B 15/06, B32B 15/08, C23C 28/00, H05K 3/38, B32B 7/04, B32B 7/10, B32B 7/12, B32B 15/082, B32B 15/095, B32B 15/098, B32B 25/16, B32B 27/28, C08J 7/04, C08L 21/00, H05K 1/03, B05D 3/10, B05D 7/02, B05D 7/00, C23C 18/18, C23C 18/20

(54) **LAMINATED BODY, MOLDED ARTICLE, ELECTROCONDUCTIVE PATTERN, ELECTRONIC CIRCUIT, AND ELECTROMAGNETIC SHIELD**
LAMINIERTER KÖRPER, FORMARTIKEL, ELEKTRISCH LEITENDES MUSTER, ELEKTRONISCHE SCHALTUNG UND ELEKTROMAGNETISCHE ABSCHIRMUNG
CORPS STRATIFIÉ, ARTICLE MOULÉ, PROFIL ÉLECTROCONDUCTEUR, CIRCUIT ÉLECTRONIQUE ET BLINDAGE ÉLECTROMAGNÉTIQUE

(30) Priority: 26.06.2015 JP 2015128836
(43) Date of publication of application: 02.05.2018
(73) Proprietor: DIC Corporation, Tokyo 174-8520 (JP)
(72) Inventor: FUJIKAWA Wataru, Takaishi-shi Osaka 592-0001 (JP); SHIRAKAMI Jun, Takaishi-shi Osaka 592-0001 (JP); MURAKAWA Akira, Takaishi-shi Osaka 592-0001 (JP); SHIMAYA Taku, Ichihara-shi Chiba 290-8585 (JP)
(74) Representative: Beckmann, Claus
(86) International application number: PCT/JP2016/068661
(87) International publication number: WO 2016/208672

(56) References cited:
- WO-A1-2007/001036
- WO-A1-2011/132542
- WO-A1-2013/147050
- JP-A- H05 320 506
- JP-A- H05 320 506
- JP-A- 2011 178 031
- JP-A- 2011 178 031
- JP-A- 2012 224 754
- JP-A- 2012 224 754
- JP-A- 2015 066 735
- JP-A- 2015 066 735
- US-A1- 2009 118 405
- US-A1- 2013 078 471
- US-A1- 2015 068 907

## Description

### Technical Field

The present invention relates to a laminated body that is usable as a molded article, such as a connector for connecting wirings of an electronic circuit, optical communication, and the like, and a lamp reflector, and as an electroconductive pattern provided on an electronic circuit on which wires are mounted, such as a printed wiring board, an electromagnetic shield, an integrated circuit, and an organic transistor. The present invention also relates to a molded article, an electroconductive pattern, and an electronic circuit that are produced by using the laminated body.

### Background Art

With increasing performance and decreasing size and thickness of electronic devices, electronic circuits and integrated circuits used therein are strongly desired to have a higher density and a reduced thickness. On the other hand, polyphenylene sulfide attracts attention as an engineering plastic having thermal resistance and chemical resistance, and it is used, for example, in an optical pickup for Blu-ray, DVD, and the like, an electronic circuit board, a wiring connector, and a film capacitor. Also in applications for automobiles, polyphenylene sulfide is used for a lamp reflector, an electrical member, an electric motor-related member, a battery member, and the like.

However, polyphenylene sulfide, which has a problem of a very low adhesiveness to a metal film formed by metal deposition, metal plating, and the like, has not been able to be used satisfactorily for applications in which a metal film is to be formed on a surface of the polyphenylene sulfide.

A process for enhancing the adhesiveness of polyphenylene sulfide to a metal film has been developed to include etching a surface of polyphenylene sulfide with an etching liquid, adding a palladium catalyst to the surface, and then subjecting the surface to electroless copper plating to form a copper-plating layer (for example, see PTL 1). However, this process has a problem in that the surface of polyphenylene sulfide becomes brittle due to erosion by the etching liquid, and therefore the copper-plating layer formed thereon becomes likely to peel with time. Accordingly, when produced by this process, an electroconductive pattern has problems of causing disconnection of the copper-plating layer and reduction in the conductivity (increase in resistance value).

In addition, a process for enhancing adhesiveness to a film of metal deposition, metal plating, or the like has been developed to include roughening a surface of polyphenylene sulfide by sand blasting, shot blasting, or the like, and then applying a primer resin on the surface (see, PTL 2). However, the surface of polyphenylene sulfide is to be roughened to a depth of 1 to 10 µm for ensuring a sufficient adhesiveness in this process. Accordingly, this process has not been suitable for a material whose surface is desired to have smoothness as in a mirror surface, such as a lamp reflector.

Thus, there is a demand for a laminated body that includes a polyphenylene sulfide as a support, and that is excellent in adhesiveness to a metal film formed thereon by metal deposition, metal plating, or the like, and that can be used as an molded article, such as a connector for connecting wirings of an electronic circuit, optical communication, and the like, and a lamp reflector, and as an electroconductive pattern provided on an electronic circuit on which wires are mounted, such as a printed wiring board, an electromagnetic shield, an integrated circuit, and an organic transistor.

JP 2015 066735 A relates to the problem to provide a composite molding formed by joining a molded article formed of a polyphenylene sulfide resin composition and a metal foil with high adhesion therebetween, and a method for manufacturing the same. As a solution to the problem, the document describes that a composite molding is formed by joining a molded article formed of a polyphenylene sulfide resin composition obtained by blending (B) 1-50 parts by weight of an epoxy resin having an epoxy equivalent of 160-10,000 g/eq with respect to 100 parts by weight of a polyphenylene sulfide resin, and a metal foil.

JP 2011 178031 A relates to the problem to provide a film-like molding and a laminate, especially those to be used in printed boards. As a solution to the problem, the document describes a film-like molding which is made of a resin composition based on a polyphenylene sulfide resin and which has a mixed-resin layer composed of a resin mixture with a polyphenylene sulfide resin (A) as a continuous phase and an olefinic copolymer (B) as a dispersed phase, in the vicinity of the surface of at least one side of the molding.

US 2009/118405 A1 describes a polyphenylene sulfide resin coated article comprising: a molded article (A) of a polyphenylene sulfide resin material (a) which comprises a polyphenylene sulfide resin (a1), and a coated film layer (B) which is formed by applying a coating which comprises as a solid component a chlorinated polyolefin resin (b1) having a chlorine atom content of 20 to 45% by mass on the surface of the molded article (A).

JP 2012 224754 A relates to the problem to provide an inexpensive resin composition low in dielectric constant and excellent in molding processability, heat resistance, impact resistance, and ductility. As a solution to the problem, the document describes a resin composition which comprises (A) the polyphenylene ether, (B) polyphenylene sulfide, and (C) an epoxy group-containing ethylene copolymer or epoxy group-containing styrene block copolymer, in which polystyrene is grafted, wherein the component (A) is a sequential phase, and the components (B) and (C) are each a disperse phase.

JP H05 320506 A relates to the problem to obtain a lamp reflector made of a resin, excellent in heat resistance, high-temperature rigidity, surface smoothness and adhesion of resin surfaces, especially the adhesion at high temperatures and high humidities with hardly any warpage and deformation in injection molding and capable of reducing the weight. As a solution to the problem, the document describes a lamp reflector which is obtained by molding a resin composition comprising (A) a polyphenylene sulfide and (B) a polyphenylene ether (PPE) or a functionalized PPE resin functionalized with a styrenic resin and/or maleic anhydride at 280-330 °C, as necessary, coating the surface to be a reflecting surface of the resultant molding with a primer, baking the primer and subsequently forming an aluminum metallic film by a vacuum deposition method.

US 2015/068907 A1 aims to provide a laminate, such as a conductive pattern, having an excellent adhesion at the interfaces between a layer that serves as a support and a conductive layer containing a conductive material and between the conductive layer and a plating layer. As a solution to the problem, the document describes a laminate at least including a support layer (I), a conductive layer (II) having an oxidized surface, and a plating layer (III) formed on the oxidized surface of the conductive layer (II); the document also describes a conductive pattern and electric circuit each including such a laminate.

### Citation List

### Patent Literature

[PTL 1] JP-A-63-14880
[PTL 2] JP-A-2002-97292

### Summary of Invention

### Technical Problem

A problem to be solved by the present invention is to provide a laminated body including a polyphenylene sulfide as a support and a metal-plating layer provided on the support. The laminated body is excellent in adhesiveness of the support with the metal-plating layer and has high thermal resistance so as to maintain the excellent adhesiveness even when exposed to a high-temperature environment. Another problem is to provide a molded article, an electroconductive pattern, and an electronic circuit that are produced by using the laminated body.

### Solution to Problem

As a result of intensive study for solving the above problem, the present inventors found that a laminated body produced by using a support including a polyphenylene sulfide resin composition containing a specific amount of an elastomer is excellent in adhesiveness to the metal-plating layer, and has high thermal resistance so that the laminated body can maintain excellent adhesiveness even when exposed to a high-temperature environment.

Specifically, the present invention provides a laminated body including a support (A) that includes a polyphenylene sulfide resin composition containing a polyphenylene sulfide (a1) and an elastomer (a2), a primer resin layer (X), and a metal layer (B) and a metal-plating layer (C) that are laminated on the support in this order, a resin constituting the primer resin layer (X) being one or more resins selected from the group consisting of a core-shell-type composite resin containing a urethane resin as a shell and a vinyl resin obtained by polymerizing a monomer including N-alkylol (meth)acrylamide as a core, a melamine resin, and a phenol block isocyanate, wherein the elastomer (a2) is contained in the polyphenylene sulfide resin composition in an amount in the range of 2 to 20 parts by mass relative to 100 parts by mass of the polyphenylene sulfide (a1), and also provides an electroconductive pattern and an electronic circuit produced by using the laminated body.

### Advantageous Effects of Invention

The laminated body of the present invention is excellent in adhesiveness of the support including a polyphenylene sulfide resin composition with the metal-plating layer laminated thereon, and in addition, can maintain the excellent adhesiveness even when exposed to a high-temperature environment. Accordingly, the present invention can provide a laminated body that can maintain excellent conductivity without causing disconnection and the like and that can be used in a highly reliable electroconductive pattern and electronic circuit.

In addition, the laminated body of the present invention can be used in, for example, a connector for connecting wirings of an electronic circuit, optical communication, and the like and an optical pickup for Blu-ray, DVD, and the like; a lamp reflector, an electrical member, an electric motor-related member, and a battery member for automobiles; and an electromagnetic shield for use in various electronic devices. Furthermore, the laminated body of the present invention including a polyphenylene sulfide in a film form as a support can be used for forming layers and peripheral wirings constituting, for example, a flexible printed wiring board, an RFID, such as a non-contact IC card, and a film capacitor.

### Description of Embodiments

The laminated body of the present invention includes a support (A) that includes a polyphenylene sulfide resin composition containing a polyphenylene sulfide (a1) and an elastomer (a2), a primer resin layer (X), and a metal layer (B) and a metal-plating layer (C) that are laminated on the support in this order, a resin constituting the primer resin layer (X) being one or more resins selected from the group consisting of a core-shell-type composite resin containing a urethane resin as a shell and a vinyl resin obtained by polymerizing a monomer including N-alkylol (meth)acrylamide as a core, a melamine resin, and a phenol block isocyanate, wherein the elastomer (a2) is contained in the polyphenylene sulfide resin composition in an amount in the range of 2 to 20 parts by mass relative to 100 parts by mass of the polyphenylene sulfide (a1).

The polyphenylene sulfide (a1) has a resin structure having as a repeating unit a structure including an aromatic ring and a sulfur atom bound to each other, and specifically the polyphenylene sulfide (a1) is a resin having as a repeating unit a structural moiety represented by the following general formula (1). 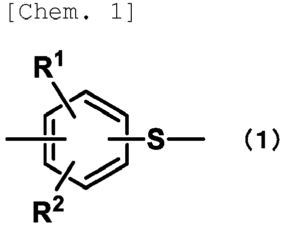 (In the formula, R¹ and R² each independently represent a hydrogen atom, an alkyl group having 1 to 4 carbon atoms, a nitro group, an amino group, a phenyl group, a methoxy group, and an ethoxy group.)

R¹ and R² in the general formula (1) are preferably a hydrogen atom, since such a structure enhances the mechanical strength of the polyphenylene sulfide (a1), and in this case, a para-bonded form represented by the following general formula (2) and a meta-bonded form represented by the following general formula (3) are exemplified.

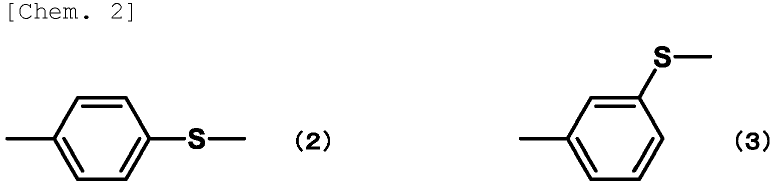

Among them, the sulfur atom in the repeating unit bonds to the aromatic ring particularly preferably at a para-position as represented by the general formula (2), since such a structure enhances the thermal resistance and crystallinity of the polyphenylene sulfide (a1).

In addition, the polyphenylene sulfide (a1) may have not only the structural moiety represented by the general formula (1) but also at least one selected from the structural moieties represented by the following general formulae (4) to (7). In the case where any structural moiety/moieties represented the following general formulae (4) to (7) is/are included, the molar ratio of the structural moiety/moieties in the polyphenylene sulfide (a1) is preferably 30% by mole or less and more preferably 10% by mole or less because of improved thermal resistance and mechanical strength.

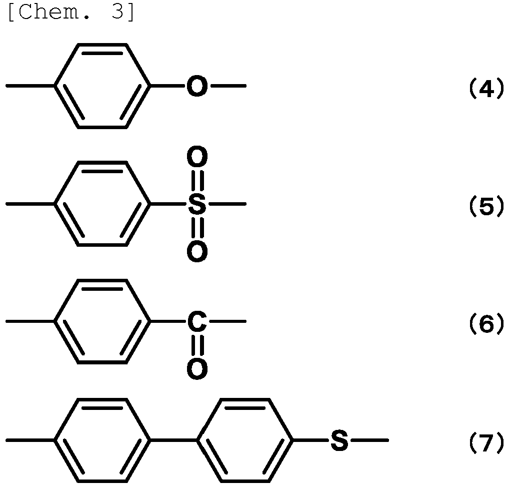

When any structural moiety represented by the general formulae (4) to (7) is contained in the polyphenylene sulfide (a1), the binding thereof with the repeating unit of the structural moiety represented by the general formula (1) may be of a random type or a block type.

Furthermore, the polyphenylene sulfide (a1) may have in the structure thereof a trifunctional structural moiety represented by the following general formula (8), a naphthyl sulfide bond, or the like. In this case, the molar ratio of the structural moiety in the polyphenylene sulfide (a1) is preferably 3% by mole or less, and particularly preferably 1% by mole or less.

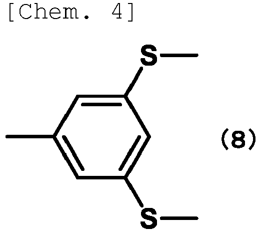

The polyphenylene sulfide (a1) may be produced, for example, by any process of the following (1) to (4).
(1) A process of allowing sodium sulfide to react with p-dichlorobenzene in an amide solvent, such as N-methylpyrrolidone and dimethylacetamide, or a sulfone solvent, such as sulfolane.
(2) A process of polymerizing p-dichlorobenzene in the presence of sulfur and sodium carbonate.
(3) A process of dropwise adding sodium sulfide, dropwise adding a mixture of sodium hydrogen sulfide and sodium hydroxide, or dropwise adding a mixture of hydrogen sulfide and sodium hydroxide, into a mixed solvent of a polar solvent and p-dichlorobenzene, thereby causing polymerization of p-dichlorobenzene.
(4) A process of subjecting p-chlorothiophenol to selfcondensation.

Among them, the process (1) of allowing sodium sulfide to react with p-dichlorobenzene in an amide solvent, such as N-methylpyrrolidone and dimethylacetamide, or a sulfone solvent, such as sulfolane, is preferred since the reaction can be easily controlled so that the process is excellent in the industrial productivity. In addition, in the process (1), an alkali substance, such as an alkali metal salt of a carboxylic acid, and an alkali metal salt of a sulfonic acid, and a hydroxide, is preferably added for adjusting the polymerization degree.

The polyphenylene sulfide (a1) preferably has a melt flow rate (hereinunder, abbreviated to as "MFR") in the range of 1 to 3,000 g/10 minutes, more preferably 5 to 2,300 g/10 min, and further preferably 10 to 1,500 g/10 min, because of excellent moldability and surface strength. Incidentally, the melt flow rate is a value measured in accordance with ASTM D1238-86 at 316°C and 5,000 g load (orifice: 0.0825 ± 0.002 inches diameter × 0.315 ± 0.001 inches length).

Furthermore, the polyphenylene sulfide (a1) is preferably subjected to an acid treatment and then washed with water after being produced, which can reduce the amount of remaining metal ions to improve characteristics of moisture resistance and reduce the amount of the remaining low-molecular weight impurities produced as by-products during polymerization.

Preferred examples of an acid used for the acid treatment include acetic acid, hydrochloric acid, sulfuric acid, phosphoric acid, silicic acid, carbonic acid, and propyl acid. Among the acids, acetic acid and hydrochloric acid are preferred since the amount of remaining metal ions can be efficiently reduced without degradation of the polyphenylene sulfide (a1).

Examples of the process of the acid treatment include a process of immersing the polyphenylene sulfide (a1) in an acid or an aqueous solution of an acid. In this case, stirring or heating may be applied as needed.

As a specific example of the acid treatment process, a process with acetic acid is now described. In this process, first, an aqueous solution of acetic acid of pH 4 is heated to 80 to 90°C, the polyphenylene sulfide (a1) is immersed therein, and the solution is stirred for 20 to 40 minutes.

The thus acid-treated polyphenylene sulfide (a1) is washed with water or hot water several times to physically remove the remaining acid and salt. The water used here is preferably distilled water or deionized water.

The polyphenylene sulfide (a1) to be subjected to the acid treatment is preferably in a form of particles or granules, and specifically may be particles or granules like pellets or those in a form of slurry after polymerization.

The elastomer (a2) is used for the purpose of imparting flexibility or low temperature impact resistance to the polyphenylene sulfide resin composition constituting the support (A), but also has a function to enhance the adhesiveness to the metal layer (B) and a primer resin layer (X) which are described later.

It is preferred that the elastomer (a2) can be melt-kneaded with the polyphenylene sulfide (a1) and uniformly mixed and dispersed therein. Specifically, a preferred example of the elastomer (a2) has a melting point of 300°C or less and has rubber elasticity at room temperature.

Examples of the elastomer (a2) include a thermoplastic elastomer, such as a polyolefin-based elastomer and an olefin copolymer-based elastomer. More specific examples include a styrene-butadiene-based rubber (SBR), a hydrogenated SBR, an ethylene-propylene-based rubber (EPM), an ethylene-propylene-diene-based rubber (EPDM), a butadiene-based rubber, a chloroprene-based rubber, a nitrile-based rubber, a butyl-based rubber, an acrylic rubber, a silicone-based rubber, a fluorine-based rubber, and a urethane-based rubber. Among them, an olefin copolymer-based elastomer is preferred, an ethylene copolymer-based elastomer is more preferred, and an elastomer having a glycidyl group is further preferred, since the adhesiveness to the metal layer (B) or the primer resin layer (X) described later is further enhanced. The elastomer (a2) may be used alone or in combination of two or more kinds thereof.

Examples of the ethylene copolymer-based elastomer include a binary copolymer whose starting monomer components are ethylene and maleic anhydride, or ethylene and an α, β-unsaturated carboxylic acid glycidyl ester. The examples also include a ternary copolymer whose monomer components are the above two monomer components of a binary copolymer and an α,β-unsaturated carboxylic acid alkyl ester. Among them, a ternary copolymer is preferred because of excellent bent elasticity and elongation in tension. Among such ternary copolymers, a ternary copolymer of ethylene, an α,β-unsaturated carboxylic acid alkyl ester, and an α,β-unsaturated carboxylic acid glycidyl ester is more preferred since compatibility with the polyphenylene sulfide (a1) can be drastically enhanced and the adhesiveness to the metal layer (B) or the primer resin layer (X) described later is further enhanced.

The ratio of the monomer components in the ternary copolymer is preferably in the range of [50 to 98/1 to 30/1 to 30] by mass in the case of a ternary copolymer of [ethylene/α,β-unsaturated carboxylic acid alkyl ester/maleic anhydride], and in the range of [50 to 98/1 to 49/1 to 10] by mass in the case of a ternary copolymer of [ethylene/α,β-unsaturated carboxylic acid alkyl ester/α,β-unsaturated carboxylic acid glycidyl ester], because of excellent balance of properties, such as the impact strength and the elongation in tension of the polyphenylene sulfide resin composition and the compatibility with the polyphenylene sulfide (a1).

Examples of the α,β-unsaturated carboxylic acid alkyl ester include an alkyl ester of an unsaturated carboxylic acid having 3 to 8 carbon atoms, such as acrylic acid and methacrylic acid. Specific examples include methyl acrylate, ethyl acrylate, n-propyl acrylate, isopropyl acrylate, n-butyl acrylate, t-butyl acrylate, isobutyl acrylate, methyl methacrylate, ethyl methacrylate, n-propyl methacrylate, isopropyl methacrylate, n-butyl methacrylate, t-butyl methacrylate, and isobutyl methacrylate. Among them, methyl acrylate, ethyl acrylate, n-butyl acrylate, and methyl methacrylate are preferred since the impact resistance of the polyphenylene sulfide resin composition and the adhesiveness to the metal layer (B) or the primer resin layer (X) described later are further enhanced.

The amount of the elastomer (a2) contained in the polyphenylene sulfide resin composition is in the range of 2 to 20 parts by mass relative to 100 parts by mass of the polyphenylene sulfide (a1). The amount is preferably in the range of 5 to 10 parts by mass, since the processability of the polyphenylene sulfide resin composition and the adhesiveness to the metal layer (B) or the primer resin layer (X) described later are further enhanced.

Further incorporation of a fibrous inorganic filler (a3) into the polyphenylene sulfide resin composition constituting the support (A), in addition to the polyphenylene sulfide (a1) and the elastomer (a2) described above, exhibits effects of further enhancing the thermal resistance, mechanical characteristics, dimension stability, crystallization kinetic, and electrical characteristics.

Examples of the fibrous inorganic filler (a3) include an inorganic fiber, such as a glass fiber, carbon fiber, zinc oxide whisker, asbestos fiber, silica fiber, aluminum borate whisker, silica-alumina fiber, zirconia fiber, boron nitride fiber, silicon nitride fiber, and potassium titanate fiber; and a metal fiber of, for example, stainless steel, aluminum, titanium, copper, and brass. Among them, a glass fiber is preferred because of high performance in electrical insulation. The fibrous inorganic filler (a3) may be used alone or in combination of two or more kinds thereof.

The fibrous inorganic filler (a3) is preferably processed with a surface treatment agent or a sizing agent, which can enhance the adhesiveness of the fibrous inorganic filler (a3) with the polyphenylene sulfide (a1), an ester-based wax (a4) described later, and other additives.

Examples of the surface treatment agent or sizing agent include a silane compound or titanate compound having a functional group, such as an amino group, an epoxy group, an isocyanate group, and a vinyl group; and a polymer, such as an acrylic resin, a urethane resin, and an epoxy resin.

The amount of the fibrous inorganic filler (a3) incorporated in the polyphenylene sulfide resin composition is preferably in the range of 10 to 150 parts by mass, more preferably 30 to 100 parts by mass, and further preferably 50 to 80 parts by mass relative to 100 parts by mass of the polyphenylene sulfide (a1), since the above effects are sufficiently exhibited.

Into the polyphenylene sulfide resin composition constituting the support (A), in addition to the components (a1) to (a3) described above, the following components may be incorporated to the extent that does not impair the effects of the present invention: an inorganic filler other than the fibrous inorganic filler (a3), such as calcium carbonate, magnesium carbonate, and talc; a high thermal resistance resin fiber, such as aramid fiber; a resin, such as polyamide, polysulfone, polyallylsulfone, polyethersulfone, polyallylate, polyphenylene oxide, polyether ketone, polyether ether ketone, polyimide, polyamide-imide, polyetherimide, a silicone resin, a phenoxy resin, a fluorine resin, a liquid crystal polymer, and polyaryl ether; and an additive of various kinds, such as a lubricant, a wax, and a stabilizer.

The process for preparing the polyphenylene sulfide resin composition is not particularly limited, and the resin composition can be prepared by a known production apparatus and process. For example, a process is exemplified in which a formulation of the polyphenylene sulfide (a1), the elastomer (a2), the fibrous inorganic filler (a3), and other components, which are previously mixed with a mixer, such as Henschel mixer and tumbler, is subjected to single- or twin-screw kneading extruder and the like, and kneaded at 250 to 350°C, and then the kneaded formulation is granulated, and pelletized.

An example of a process for molding the polyphenylene sulfide resin composition to form the support (A) is a process of molding the pellets of the polyphenylene sulfide resin composition produced by the above preparation process through injection molding, extrusion molding, compression molding, and the like.

The shape of the support (A) is not particularly limited, and the support (A) preferably has a thickness of approximately 0.5 to 100 mm, and more preferably has a thickness of approximately 0.5 to 10 mm. The support also has a three-dimensional shape molded with a mold of a connector component or the like.

The support (A) may have a form of film or sheet. The thickness of the film or sheet is preferably approximately 1 to 5,000 µm, and more preferably approximately 1 to 300 µm. When a relatively flexible material is desired as the laminated body of the present invention, the thickness is preferably approximately 1 to 200 µm.

The surface of the support (A) may be subjected to a surface treatment or the like for forming fine depressions and protrusions, washing dirt attached on the surface, and introducing a functional group, such as a hydroxyl group, a carbonyl group, and a carboxyl group, since such a treatment can further enhance the adhesiveness between the support (A) and the metal layer (B) or the primer resin layer (X) described later. Specifically, a plasma discharge treatment, such as a corona discharge treatment, a dry treatment, such as a UV treatment, and a wet treatment with water, an aqueous acid or alkali solution, an organic solvent, or the like may be applied.

In the laminated body of the present invention, for the purpose of further enhancing the adhesiveness between the support (A) and the metal layer (B), the primer resin layer (X) is formed between the support (A) and the metal layer (B).

The primer resin layer (X) can be formed by applying a primer partially or entirely on a surface of the support (A) and removing a solvent, such as an aqueous medium and an organic solvent, contained in the primer.

Examples of the process for applying the primer on the surface of the support include processes of a gravure method, a coating method, a screen method, a roller method, a rotary method, a spray method, and a dip coating method.

For the purpose of further enhancing the adhesiveness to the metal layer (B), the surface of the primer resin layer (X) is preferably surface-treated by a plasma discharge treatment process, such as a corona discharge treatment process, a dry treatment process, such as a UV treatment process, a wet treatment process with water, an acidic or alkaline chemical agent, an organic solvent, or the like.

A common example of a process for removing a solvent contained in the layer of the primer applied on the support surface is a process of drying the layer with a dryer to vaporize the solvent. The drying temperature may be set to a temperature in such a range that the solvent can be vaporized and the support (A) is not adversely affected.

The amount of the primer applied on the support (A) is preferably in the range of 0.01 to 60 g/m² based on the area of the support surface since excellent adhesiveness and conductivity can be imparted. Taking into account absorption of the solvent contained in a fluid described later and the production cost, the amount is more preferably in the range of 0.01 to 10 g/m².

The thickness of the primer resin layer (X) is different depending on the use purpose of the laminated body of the present invention, but the thickness is preferably in the range of 10 nm to 30 µm, more preferably 10 nm to 1 µm, and further preferably 10 nm to 500 nm, since the adhesiveness between the support (A) and the metal layer (B) can be further enhanced.

A resin constituting the primer resin layer (X) is one or more resins selected from the group consisting of a core-shell-type composite resin containing a urethane resin as a shell and a vinyl resin obtained by polymerizing a monomer including N-alkylol (meth)acrylamide as a core, a melamine resin, and a phenol block isocyanate,

Examples of the resin include a block isocyanate produced by allowing polyisocyanate to react with phenol as a blocking agent. Incidentally, the core-shell-type composite resin containing a urethane resin as a shell and a vinyl resin as a core is produced, for example, by polymerizing a vinyl monomer including N-alkylol (meth)acrylamide in the presence of a urethane resin. The resins may be used alone or in combination of two or more thereof.

The resins used in the primer are resins that produce a reducing compound with heat since the adhesiveness to the metal layer (B) can be further enhanced. The reducing compound is a phenol compound or an aldehyde compound (formaldehyde).

Since the resin that produces a reducing compound with heat is used as a primer, the reducing compound, such as formaldehyde and phenol, is produced in a heat-drying step in formation of the primer resin layer (X). A resin that produces formaldehyde with heat is a core-shell-type composite resin containing a urethane resin as a shell and a vinyl resin obtained by polymerizing a monomer including N-alkylol (meth)acrylamide as a core and a melamine resin; and a resin that produces a phenol compound with heat is a phenol block isocyanate. A core-shell-type composite resin containing a urethane resin as a shell and a vinyl resin obtained by polymerizing a monomer including N-alkylol (meth)acrylamide as a core, a melamine resin, or a phenol block isocyanate are used since the adhesiveness to the metal layer (B) can be further enhanced.

Incidentally, in the present invention, "(meth)acrylamide" means one or both of "methacrylamide" and "acrylamide", and "(meth)acrylic acid" means one or both of "methacrylic acid" and "acrylic acid".

The vinyl resin can be produced by polymerizing a vinyl monomer that produces a reducing compound with heat by a polymerization process, such as radical polymerization, anion polymerization, and cation polymerization.

Examples of the vinyl monomer that produces a reducing compound with heat include N-alkylol vinyl monomer, and specific examples include N-methylol (meth)acrylamide, N-methoxymethyl (meth)acrylamide, N-ethoxymethyl (meth)acrylamide, N-propoxymethyl (meth)acrylamide, N-isopropoxymethyl (meth)acrylamide, N-n-butoxymethyl (meth)acrylamide, N-isobutoxymethyl (meth)acrylamide, N-pentoxymethyl (meth)acrylamide, N-ethanol (meth)acrylamide, and N-propanol (meth)acrylamide.

When the vinyl resin is produced, another vinyl monomers of various kinds, such as a (meth)acrylic acid alkyl ester, may be copolymerized with the vinyl monomer and the like that produces a reducing compound with heat.

When the block isocyanate is used as a resin for forming the primer resin layer (X), self-reaction occurred among isocyanate groups to form a uretdione bond, or an isocyanate group forms a bond with a functional group in another component, thereby forming the primer resin layer (X). The bond may be formed before application of the fluid described later. Alternatively, the bond may be not formed before application of the fluid but formed with heat or the like after application of the fluid.

Examples of the block isocyanate include one having a functional group formed by an isocyanate group being blocked with a blocking agent.

The block isocyanate has the functional group preferably in the range of 350 to 600 g/mol per mole of block isocyanate since the adhesiveness between the support (A) and the primer resin layer (X) and the adhesiveness between the primer resin layer (X) and the metal layer (B) can be further enhanced.

The block isocyanate preferably has 1 to 10 functional groups mentioned above, and more preferably 2 to 5 functional groups in one molecule of the block isocyanate, since the adhesiveness can be further enhanced.

The block isocyanate preferably has a number average molecular weight in the range of 1,500 to 5,000, and more preferably 1,500 to 3,000, since the adhesiveness can be further enhanced.

The block isocyanate preferably has an aromatic ring, which can furthermore enhance the adhesiveness. Examples of the aromatic ring include a phenyl group and a naphthyl group.

Incidentally, the block isocyanate can be produced by allowing a part or all of isocyanate groups in the isocyanate compound (a-1) to react with a blocking agent.

Examples of the isocyanate compound as a raw material for the block isocyanate include a polyisocyanate compound having an aromatic ring, such as 4,4'-diphenylmethane diisocyanate, 2,4'-diphenylmethane diisocyanate, carbodiimide-modified diphenylmethane diisocyanate, crude diphenylmethane diisocyanate, phenylene diisocyanate, tolylene diisocyanate, and naphthalene diisocyanate; and an aliphatic polyisocyanate compound or a polyisocyanate compound having an alicyclic structure, such as hexamethylene diisocyanate, lysine diisocyanate, cyclohexane diisocyanate, isophorone diisocyanate, dicyclohexylmethane diisocyanate, xylylene diisocyanate, and tetramethyl xylylene diisocyanate. Examples also include a biuret form, an isocyanurate form, and an adduct form of the above-mentioned polyisocyanate compound.

Examples of the isocyanate compound also include a compound obtained by allowing the above-mentioned polyisocyanate compound to react with a compound having a hydroxy group or an amino group or the like.

When an aromatic ring is introduced into the block isocyanate, a polyisocyanate compound having an aromatic ring is preferably used. In addition, among the polyisocyanate compounds having an aromatic ring, 4,4'-diphenylmethane diisocyanate, tolylene diisocyanate, the isocyanurate form of 4,4'-diphenylmethane diisocyanate, and the isocyanurate form of tolylene diisocyanate are preferred.

The blocking agent for use in production of the block isocyanate is a phenol compound, such as phenol and cresol. Among them, a blocking agent that can dissociate by heating at 70 to 200°C to produce an isocyanate group is preferred, and a blocking agent that can dissociate by heating at 110 to 180°C to produce an isocyanate group is more preferred. A phenol compound is used since the blocking agent becomes a reducing compound upon elimination with heat.

Examples of a process for producing the block isocyanate include a process in which the isocyanate compound which is produced in advance and the blocking agent are mixed and allowed to react, and a process in which the blocking agent and raw materials used for producing the isocyanate compound are mixed and allowed to react.

More specifically, the block isocyanate can be produced by allowing the polyisocyanate compound to react with a compound having a hydroxide group or an amino group to produce an isocyanate compound having an isocyanate group at an end thereof, and then mixing the isocyanate compound with the blocking agent and allowing them to react with each other.

The block isocyanate obtained by the process is preferably contained in the range of 50 to 100% by mass, and more preferably 70 to 100% by mass of the total amount of the resin composition forming the primer resin layer (X). The resin composition forming the primer resin layer (X) may contain a solvent that can dissolve or disperse a solid component, such as the block isocyanate, therein. As the solvent, for example, an aqueous medium or an organic solvent may be used.

Examples of the melamine resin include mono- or poly-methylol melamine in which 1 to 6 mol of formaldehyde is added to 1 mol of melamine; an etherification product (the etherification degree is arbitrary) of (poly)methylol melamine, such as trimethoxymethylol melamine, tributoxymethylol melamine, and hexamethoxymethylol melamine; and a urea-melamine-formaldehyde-methanol condensate.

Besides the process using a resin producing a reducing compound with heat as described above, a process of adding a reducing compound to a resin is also exemplified. In this case, examples of the reducing compound to be added include a phenol-based antioxidant, an aromatic amine-based antioxidant, a sulfur-based antioxidant, a phosphoric acid-based antioxidant, vitamin C, vitamin E, ethylenediamine tetraacetic acid sodium salt, a sulfite salt, a hypophosphorous acid, a hypophosphite salt, hydrazine, formaldehyde, sodium borohydride, dimethylamine borane, and phenol.

When the laminated body of the present invention is used as an electroconductive pattern, the process using a resin that produces a reducing compound with heat is advantageous since the process of adding a reducing compound to a resin causes low molecular weight components and ionic compounds to finally remain to thereby lower the electrical characteristics.

The primer resin layer (X) preferably contains the resin at 1 to 70% by mass in the primer, and more preferably at 1 to 20% by mass, because of good application capability.

Examples of a solvent usable in the primer include an organic solvent of various kinds and an aqueous medium. Examples of the organic solvent include toluene, ethyl acetate, methyl ethyl ketone, and cyclohexanone, and examples of the aqueous medium include water, an organic solvent miscible with water, and a mixture thereof.

Examples of the organic solvent miscible with water include an alcohol solvent, such as methanol, ethanol, n-propanol, isopropanol, ethyl carbitol, ethyl cellosolve, and butyl cellosolve; a ketone solvent, such as acetone and methyl ethyl ketone; an alkylene glycol solvent, such as ethylene glycol, diethylene glycol, and propylene glycol; a polyalkylene glycol solvent, such as polyethylene glycol, polypropylene glycol, and polytetramethylene glycol; and a lactam solvent, such as N-methyl-2-pyrrolidone.

As needed, the resin may have a crosslinkable functional group, such as an alkoxysilyl group, a silanol group, a hydroxy group, and an amino group. The cross-linking structure formed by the crosslinkable functional group may be already formed before application of the fluid, or formed, for example, by heating in a sintering step or the like after application of the fluid.

In the primer resin layer (X), as needed, in addition to a crosslinking agent, a known additive, such as a pH modifier, a film forming assistant, a leveling agent, a thickener, a water repellent, and an antifoaming agent may be appropriately used.

Examples of the crosslinking agent include a metal chelate compound, a polyamine compound, an aziridine compound, a metal salt compound, and an isocyanate compound, and include a thermally-crosslinking agent that reacts at a relatively low temperature of approximately 25 to 100°C to form a cross-linking structure; a thermally-crosslinking agent that reacts at a relatively high temperature of 100°C or higher to form a crosslinking structure, such as a melamine-based compound, an epoxy -based compound, an oxazoline compound, a carbodiimide compound, and a block isocyanate compound; and a photocrosslinking agent of various kinds.

Although depending on the kind or the like, the crosslinking agent is preferably used in the range of 0.01 to 60 parts by mass, more preferably 0.1 to 10 parts by mass, and further preferably 0.1 to 5 parts by mass based on the 100 parts by mass of the total resin contained in the primer, since an the electroconductive pattern excellent in adhesiveness and conductivity and also excellent in the durability can be formed.

When the crosslinking agent is used, a cross-linking structure may be formed in the primer resin layer (X) before formation of the metal layer (B), or a cross-linking structure may be formed in the primer resin layer (X), for example, by heating in a sintering step or the like after formation of the metal layer (B).

The metal layer (B) is formed on the primer resin layer (X), and examples of the metal constituting the metal layer (B) include a transition metal or a compound thereof, and among them, an ionic transition metal is preferred. Examples of the ionic transition metal include copper, silver, gold, nickel, palladium, platinum, cobalt, and chromium. Among the ionic transition metals, copper, silver, and gold are preferred since the metals have low electric resistance and can produce an electroconductive pattern having high corrosion resistance. The metal layer (B) is preferably in a porous form, and in this case, the metal layer (B) has voids therein.

Examples of a metal constituting the metal-plating layer (C) include copper, nickel, chromium, cobalt, and tin. Among them, copper is preferred since copper has low electric resistance and can produce an electroconductive pattern having high corrosion resistance.

In the laminated body of the present invention, it is preferred that voids present in the metal layer (B) are filled with a metal constituting the metal-plating layer (C), and it is preferred that even voids in the metal layer (B) present in the vicinity of the interface between the support (A) and the metal layer (B) are filled with the metal constituting the metal-plating layer (C) since the adhesiveness between the metal layer (B) and the metal-plating layer (C) is further enhanced.

In an example of the process for producing the laminated body of the present invention, a fluid containing a nanosized metal powder and a dispersant is applied on the support (A) and then sintered, and organic compounds containing the dispersant present in the applied film of the fluid are removed to form voids, thereby forming a porous metal layer (B). Subsequently, the metal-plating layer (C) is formed by electroplating or electroless plating.

The particle shape of the nanosized metal powder for use in formation of the metal layer (B) is not limited as long as a porous metal layer is produced, but a particulate or fibrous shape is preferred. In addition, nanosized particles are used as the metal powder, and specifically, when the metal powder particles have a particulate shape, the average particle size is preferably in the range of 1 to 100 nm, and more preferably 1 to 50 nm since a fine electroconductive pattern can be formed and the resistance value after sintering can be further reduced. Incidentally, the "average particle size" is a volume average value measured by a dynamic light scattering method using the conductive substance diluted with a well-dispersible solvent. For this measurement, "Nanotrac UPA-150" manufactured by MicrotracBEL corporation can be used.

On the other hand, when the metal powder particles have a fibrous shape, the fiber preferably has a diameter in the range of 5 to 100 nm, and more preferably 5 to 50 nm, since a fine electroconductive pattern can be formed and the resistance value after sintering can be reduced more. The fiber preferably has a length in the range of 0.1 to 100 µm, and more preferably 0.1 to 30 µm.

When the metal layer (B) is formed on the primer resin layer (X), a process in which a fluid having a nanosized metal powder dispersed in a solvent is applied on the primer resin layer (X) is preferred.

The amount of the nanosized metal powder contained in the fluid is preferably in the range of 5 to 90% by mass, and more preferably 10 to 60% by mass.

As a component incorporated in the fluid, a dispersant for dispersing the nanosized metal powder in a solvent and the solvent, and as needed, an organic compound, such as a surfactant, a leveling agent, a viscosity modifier, a film forming assistant, an antifoaming agent, and antiseptic may be contained.

For dispersing the nanosized metal powder in a solvent, a dispersant of a low molecular weight or a high molecular weight is used. Examples of the dispersant include dodecanethiol, 1-octanethiol, triphenylphosphine, dodecylamine, polyethylene glycol, polyvinyl pyrrolidone, polyethyleneimine, polyvinyl pyrrolidone; a fatty acid, such as myristic acid, octanoic acid, and stearic acid; and a polycyclic hydrocarbon compound having a carboxyl group, such as cholic acid, glycyrzic acid, and abietic acid. Among them, a high molecular dispersant is preferred since the size of the voids in the metal layer (B) can be increased to enhance the adhesiveness of the metal layer (B) with the metal-plating layer (C) described later. Preferred examples of the high molecular dispersant include a polyalkyleneimine, such as polyethyleneimine and polypropyleneimine, and a compound of the polyalkyleneimine having polyoxyalkylene added thereto.

When a high molecular dispersant is used as the dispersant as described above, the size of the voids formed by removing the dispersant in the metal layer (B) can be increased as compared with a low molecular dispersant, and voids having a size of the order of nano to submicron can be formed. The voids are thus more likely to be filled with a metal constituting the metal-plating layer (C) described later, and the filling metal serves as an anchor to greatly enhance the adhesiveness between the metal layer (B) and the metal-plating layer (C).

The amount of the dispersant to be used for dispersing the nanosized metal powder is preferably 0.01 to 50 parts by mass, and more preferably 0.01 to 10 parts by mass relative to 100 parts by mass of the nanosized metal powder.

The amount is preferably 0.1 to 10 parts by mass, and more preferably 0.1 to 5 parts by mass relative to 100 parts by mass of the nanosized metal powder, since a dispersant in the metal layer (B) can be more easily removed to form voids, resulting in further enhanced adhesiveness between the metal layer (B) and the metal-plating layer (C).

As the solvent used in the fluid, an aqueous medium or an organic solvent can be used. Examples of the aqueous medium include distilled water, ion-exchanged water, pure water, and ultra-pure water. Examples of the organic solvent include an alcohol compound, an ether compound, an ester compound, and a ketone compound.

Examples of the alcohol include methanol, ethanol, n-propanol, isopropyl alcohol, n-butanol, isobutyl alcohol, sec-butanol, tert-butanol, heptanol, hexanol, octanol, nonanol, decanol, undecanol, tridecanol, tetradecanol, pentadecanol, stearyl alcohol, allyl alcohol, cyclohexanol, terpineol, terpineol, dihydroterpineol, ethylene glycol monomethyl ether, ethylene glycol monoethyl ether, ethylene glycol monobutyl ether, diethylene glycol monoethyl ether, diethylene glycol monomethyl ether, diethylene glycol monobutyl ether, tetraethylene glycol monobutyl ether, propylene glycol monomethyl ether, dipropylene glycol monomethyl ether, tripropylene glycol monomethyl ether, propylene glycol monopropyl ether, dipropylene glycol monopropyl ether, propylene glycol monobutyl ether, dipropylene glycol monobutyl ether, and tripropylene glycol monobutyl ether.

In the fluid, besides the above-mentioned metal powder and solvent, ethylene glycol, diethylene glycol, 1,3-butanediol, isoprene glycol, and the like may be used as needed.

As the surfactant, a general surfactant may be used, and examples include a di-2-ethylhexyl sulfosuccinic acid salt, a dodecylbenzenesulfonic acid salt, an alkyl diphenyl ether disulfonic acid salt, an alkylnaphthalenesulfonic acid salt, and a hexametaphosphoric acid salt.

As the leveling agent, a general leveling agent may be used, and examples include a silicone-based compound, an acethylenediol-based compound, and a fluorine-based compound.

As the viscosity regulator, a general thickening agent may be used, and examples include an acrylic polymer and a synthetic rubber latex which can increase viscosity through regulation to alkali, and a urethane resin, hydroxyethyl cellulose, carboxymethyl cellulose, methylcellulose, polyvinyl alcohol, hydrogenated castor oil, amide wax, oxidized polyethylene, metal soap, and dibenzylidene sorbitol which can increase viscosity through molecule association.

As the film forming assistant, a general film forming assistant may be used, and examples include an anion-based surfactant (dioctyl sulfosuccinic acid ester sodium salt, and the like), a hydrophobic nonion-based surfactant (sorbitan monooleate, and the like), a polyether-modified siloxane, and a silicone oil.

As the antifoaming agent, a general antifoaming agent may be used, and examples include a silicone-based antifoaming agent, a nonion-based surfactant, a polyether, a higher alcohol, and a polymer-based surfactant.

As the antiseptic, a general antiseptic may be used, and examples include an isothiazoline-based antiseptic, a triazine-based antiseptic, an imidazole-based antiseptic, a pyridine-based antiseptic, an azole-based antiseptic, an iodine-based antiseptic, and a pyrithione-based antiseptic.

The viscosity of the fluid (as measured with a Brookfield viscometer at 25°C) is preferably in the range of 0.1 to 500,000 mPa·s, and more preferably 0.5 to 10,000 mPa·s. When the fluid is applied (printed) by a process, such as an inkjet printing process and a relief reverse printing process which are described later, the viscosity is preferably in the range of 5 to 20 mPa·s.

Examples of the process for applying the fluid on the primer resin layer (X) include an inkjet printing process, a reverse printing process, a screen printing process, an offset printing process, a spin coating process, a spray coating process, a bar coating process, a die coating process, a slit coating process, a roll coating process, and a dip coating process.

Among such application processes, an inkjet printing process or a reverse printing process is preferably used in formation of the metal layer (B) having fine lines patterned at approximately 0.01 to 100 µm, which is desired in an electronic circuit and the like for increasing density.

For the inkjet printing process, an apparatus generally called inkjet printer may be used. Specific examples include Konica Minolta EB100 and XY100 (manufactured by Konica Minolta Inc.), and Dimatix Material Printer DMP-3000 and DMP-2831 (manufactured by FUJIFILM Corporation).

As a reverse printing process, a relief reverse printing process and an intaglio reverse printing process are known. In an example, the fluid, which is applied on a surface of a blanket of various kinds, is brought into contact with a plate having a protruded non-image area to selectively transfer the fluid corresponding to the non-image area onto the surface of the plate, thereby forming the pattern on the surface of the blanket, and then the pattern is transferred on (a surface of) the support (A).

The metal layer (B) is obtained, for example, by applying a fluid containing a metal powder, followed by a sintering step. Through the sintering step, metal powder particles in the fluid can be densely adhered together, thereby forming the conductive metal layer (B). The sintering step is preferably performed at 80 to 300°C for approximately 2 to 200 minutes. The sintering step may be performed in the air. Alternatively, the sintering step may be partially or entirely performed in a reducing atmosphere for preventing complete oxidation of the metal powder.

With such a sintering step, the particulate or fibrous metal powder particles used for forming the metal layer (B) are densely adhered together and in addition, organic compounds, such as a dispersant, contained in the fluid are removed, thereby making the metal layer (B) porous.

The sintering step can be performed by using, for example, an oven, a hot air dryer, an infrared dryer, laser irradiation, microwave, and photoirradiation (a flash irradiator).

The attached amount of the metal layer (B) formed through the sintering step is preferably in the range of 1 to 30,000 mg/m², more preferably 50 to 10,000 mg/m², and further preferably 50 to 5,000 mg/m², in view of the adhesiveness to the metal-plating layer (C) described later.

Organic compounds, such as a dispersant, that are contained in the fluid and can not be removed even by the sintering step can be removed by a plasma discharge treatment process, an electromagnetic radiation treatment process, a laser radiation treatment process, and a dissolving treatment process in which the organic compounds including a dispersant are re-dispersed and dissolved in water or an organic solvent. The treatment processes may be used alone or in combination of two or more thereof. A combination of two or more processes is preferred since the organic compounds can be more efficiently removed. Incidentally, the organic compounds as used herein mean components contained in the fluid, such as a dispersant, a solvent, a surfactant, a leveling agent, a viscosity regulator, a film forming assistant, an antifoaming agent, an antiseptic, and other organic compounds.

Examples of the plasma discharge treatment process include a normal pressure plasma discharge treatment process, such as a corona discharge treatment process, and a vacuum plasma discharge treatment process, such as a glow discharge treatment process and an arc discharge treatment process performed in vacuum or under a reduced pressure.

In an example of the normal pressure plasma discharge treatment process, a plasma discharge treatment is performed at an atmosphere of an oxygen concentration of approximately 0.1 to 25 % by volume. The oxygen concentration is preferably in the range of 10 to 22 % by volume, and more preferably about 21% by volume (in an air atmosphere), since the adhesiveness between the metal layer (B) and the metal-plating layer (C) is enhanced and the voids in the porous metal layer (B) are easily filled with a metal constituting the metal-plating layer (C) to enhance the adhesiveness between the metal layer (B) and the metal-plating layer (C).

The normal pressure plasma discharge treatment process is preferably performed in an environment containing an inert gas in addition to oxygen mentioned above since excessive depressions and protrusions are not formed on the metal layer
(B) surface and the adhesiveness between the metal layer (B) and the metal-plating layer (C) can be further enhanced. Incidentally, examples of the inert gas include argon and nitrogen.

One example of the apparatus usable for treatment by the normal pressure plasma discharge treatment process is a normal pressure plasma treatment apparatus "AP-T01" manufactured by Sekisui Chemical Co., Ltd.

The flow rate of the gas, such as air, in a treatment by the normal pressure plasma discharge treatment process is preferably in the range of 5 to 50 L/min. The output is preferably in the range of 50 to 500 W. The time for treatment is preferably in the range of 1 to 500 seconds.

Among the normal pressure plasma discharge treatment processes, a corona discharge treatment process is preferably used. An example of an apparatus usable in the corona discharge treatment process is a corona surface modification evaluation apparatus "TEC-4AX" manufactured by KASUGA (Patlite Corporation).

The output in a treatment by the corona discharge treatment process is preferably in the range of 5 to 300 W. The time for treatment is preferably in the range of 0.5 to 600 seconds.

The plasma discharge treatment process is preferred since the process can remove the organic compounds present in the metal layer (B) even in a deep portion and thus can remove the organic compounds in the metal layer (B) present in the vicinity of the interface between the support (A) and the metal layer (B). When the plasma discharge treatment process is used, voids in the porous metal layer (B) are likely to be filled with a metal constituting the metal-plating layer (C) in formation of the metal-plating layer (C), and even voids in the metal layer (B) present in the vicinity of the interface of the support (A) and the metal layer (B) are easily filled with the metal constituting the metal-plating layer (C). Accordingly, the metal constituting the metal-plating layer (C) enters a deeper portion of the metal layer (B) to exert a great anchoring effect, resulting in significant enhancement of the adhesiveness between the metal layer (B) and the metal-plating layer (C).

In the electromagnetic irradiation treatment process, the metal layer (B) is heated at a high temperature by being irradiated with an electromagnetic wave, which causes an organic compound to be degraded and removed. The electromagnetic wave can selectively remove a dispersant by electromagnetic wave absorption resonance. The wave length of the electromagnetic wave that resonates with the organic compound present in the metal layer (B) is determined in advance, and the metal layer (B) is irradiated with an electromagnetic wave having the determined wave length. Absorption into the organic compound thus increases (resonance), and only a dispersant can be removed by controlling the magnetic wave intensity.

In the laser irradiation treatment process, the metal layer (B) is irradiated with a laser, whereby an organic compound in the metal layer (B) can be degraded and removed. In the laser irradiation treatment process, a laser that can perform a laser scribing treatment may be used. Examples of the laser that can perform a laser scribing treatment include a YAG laser, a CO₂ laser, and an excimer laser, and a YAG laser is particularly preferred. Not only light having a fundamental wave length of 1.06 µm but also light having a second harmonic of 0.53 µm obtained by using a nonlinear optical device can be used as desired. As the YAG laser, a pulse laser is preferably used for achieving a high peak power and a high frequency.

In a specific process for irradiating the metal layer (B) with a laser, a surface of the metal layer (B) in conveyance is irradiated with a laser beam converged with a lens after emitted from a laser source. At this time, the laser beam is moved with a polygonal mirror to scan the surface of the metal layer (B) in conveyance. Thus, the metal layer (B) can be heated at a high temperature. In the laser irradiation treatment, it is preferred that the output of the laser light is 0.1 to 100 kW, the frequency of pulsed oscillation (oscillatory frequency) is several kHz to several tens of kHz, and the duration of one pulse (pulse width) is 90 to 100 nanoseconds.

The dissolving treatment process is a process for removing an organic compound present in the metal layer (B) by re-dispersing and dissolving the organic compound in water or an organic solvent. Examples of the organic solvent include an alcohol-based solvent, such as methanol, ethanol, and isopropyl alcohol; an aprotic polar solvent, such as dimethyl sulfoxide, dimethyl formamide, and N-methylpyrrolidone; and tetrahydrofuran, methyl ethyl ketone, ethyl acetate, and Ecuamide (organic solvent manufactured by Idemitsu Kosan Co. Ltd.).

In addition, an acid or alkali is preferably used for re-dispersing and dissolving the organic compound, and an alkali is more preferably used. Examples of the acid include sulfuric acid, nitric acid, hydrochloric acid, phosphoric acid, oxalic acid, acetic acid, formic acid, propionic acid, succinic acid, glutaric acid, tartaric acid, and adipic acid. Among them, a strong acid, such as sulfuric acid, nitric acid, and hydrochloric acid is preferably used. Furthermore, when the metal-plating layer (C) is formed by a copper electroplating process using copper sulfate, sulfuric acid is preferably used in order not to incorporate impurities into the subsequent steps.

Examples of the alkali include sodium hydroxide, potassium hydroxide, lithium hydroxide, calcium hydroxide, ammonia, an organic amine, such as triethyl amine, pyridine, and morpholine, and an alkanol amine, such as monoethanolamine. Among them, a strong alkali, such as sodium hydroxide and potassium hydroxide, is preferably used.

A surfactant may be used for re-dispersing and dissolving the organic compound. As the surfactant, a general surfactant may be used, and examples include a di-2-ethylhyxyl sulfosuccinic acid salt, an alkylsulfuric acid salt, an alkylbenzene sulfonic acid salt, and an alkyl diphenyl ether disulfonic acid salt. The surfactants are more preferred since the surfactants show an alkalinity when dissolved in water and thus can easily remove the organic compound.

Next, in a manner as described above, the porous metal layer (B) having voids is formed on the support (A) by removal of the organic compound, and then the metal-plating layer (C) is formed on the metal layer (B), whereby the laminated body of the present invention can be obtained.

The metal-plating layer (C) is a layer provided for the purpose of forming a reliable wiring pattern that can keep a good conductivity for a long period of time without causing disconnection and the like when the laminated body is used for an electroconductive pattern or the like.

The metal-plating layer (C) is a layer formed on the metal layer (B). The forming process is preferably a process by a plating treatment. Examples of the plating treatment include a wet plating process, such as an electroplating process and an electroless plating process, and a dry plating process, such as a spattering process and a vacuum deposition process. Two or more of the plating processes may be combined to form the metal-plating layer (C).

Among the plating treatments, a wet plating process, such as an electroplating process and an electroless plating process, is preferred and an electroplating process is more preferred, since voids in the porous metal layer (B) are easily filled with a metal constituting the metal-plating layer (C), thereby further enhancing the adhesiveness between the metal layer (B) and the metal-plating layer (C) and producing an electroconductive pattern excellent in conductivity.

In the electroless plating process, for example, an electroless plating liquid is brought into contact with a metal constituting the metal layer (B) to thereby precipitate a metal, such as copper, contained in the electroless plating liquid, thus forming an electroless plating layer (film) of a metal film.

Examples of the electroless plating liquid include a liquid containing a metal, such as copper, nickel, chromium, cobalt, and tin, a reductant, and a solvent, such as an aqueous medium and an organic solvent.

Examples of the reductant include dimethylaminoborane, hypophosphorous acid, sodium hypophosphite, dimethylamine borane, hydrazine, formaldehyde, sodium borohydride, and phenol.

As the electroless plating liquid, a liquid containing the following compound as needed can be used: an organic acid, for example, a monocarboxylic acid, such as acetic acid and formic acid; a dicarboxylic acid compound, such as malonic acid, succinic acid, adipic acid, maleic acid, and fumaric acid; a hydroxycarboxylic acid compound, such as malic acid, lactic acid, glycolic acid, gluconic acid, and citric acid; an amino acid compound, such as glycine, alanine, iminodiacetic acid, arginine, aspartic acid, and glutamic acid; and an amino polycarboxylic acid compound, such as iminodiacetic acid, nitrilotriacetic acid, ethylenediamine diacetic acid, ethylenediamine tetraacetic acid, and diethylenetriamine pentaacetic acid, or a soluble salt of the organic acid (sodium salt, potassium salt, ammonium salt, and the like), and a complexing agent, for example, an amine compound, such as ethylenediamine, diethylenetriamine, and triethylenetetramine.

The electroless plating liquid is preferably used at 20 to 98°C.

In an example of the electroplating process, in a state where a surface of a metal constituting the metal layer (B) or a surface of an electroless plating layer (film) formed by the electroless treatment is in contact with an electroplating liquid, electricity is applied to cause a metal, such as copper, contained in the electroplating liquid to precipitate on a surface of a conductive substance constituting the metal layer (B) or a surface of the electroless plating layer (film) that is formed by the electroless treatment set as a cathode, thereby forming an electroplating layer (metal film).

Examples of the electroplating liquid include a liquid containing a sulfide of a metal, such as copper, nickel, chromium, cobalt, and tin, sulfuric acid, and an aqueous medium. One specific example is a liquid containing copper sulfate, sulfuric acid, and aqueous medium.

The electroplating liquid is preferably used at 20 to 98°C.

In the electroplating treatment process, the metal-plating layer (C) of copper is preferably formed using an electroplating process because of high workability with no toxic substance.

As the dry plating treatment process, a spattering process, a vacuum deposition process, and the like can be used. In the spattering process, with an inert gas (mainly argon) introduced in vacuum, minus ions are applied to a material for forming the metal-plating layer (C) to generate glow discharge. Then, the inert gas atom is ionized and the generated gas ions are allowed to strongly beat a surface of the material for forming the metal-plating layer (C) at a high speed. The gas ions sputter the atoms and molecules constituting the material for forming the metal-plating layer (C), and then the sputtered atoms and molecules are powerfully attached onto the surface of the metal layer (B), whereby the metal-plating layer (C) is thus formed.

Examples of the material for forming the metal-plating layer (C) by the spattering process include chromium, copper, titanium, silver, platinum, gold, nickel-chromium alloy, stainless steel, copper-zinc alloy, indium tin oxide (ITO), silicon dioxide, titanium dioxide, niobium dioxide, and zinc oxide.

In a plating treatment by the spattering process, for example, a magnetron sputtering apparatus may be used.

The metal-plating layer (C) preferably has a thickness of 1 to 50 µm. The thickness of the metal-plating layer (C) can be adjusted by controlling the time for treatment, the current density, the amount of an additive for plating used, and the like in the plating treatment step in forming the metal-plating layer (C).

The laminated body of the present invention obtained by the above process can be used as an electroconductive pattern. When the laminated body of the present invention is used as an electroconductive pattern, a fluid containing the metal powder is applied or printed so as to form the metal layer (B) at a position corresponding to a desired pattern shape to be formed, followed by sintering, whereby an electroconductive pattern having the desired pattern can be produced.

Alternatively, the electroconductive pattern can be produced, for example, by a subtractive process in which the metal layer (B) and the metal-plating layer (C) are etched from a metal solid film to produce an electroconductive pattern, a photolitho-etching, such as a semi-additive process, or a process of applying plating on a printing pattern of the metal layer (B).

In the subtractive process, an etching resist layer having a shape corresponding to a desired pattern shape is formed on the metal-plating layer (C) constituting the laminated body of the present invention which is previously produced, and through a subsequent development treatment, the metal-plating layer (C) and the metal layer (B) in a part where the resist has been removed are removed by dissolution with a chemical agent, whereby the desired pattern is formed. As the chemical agent, an agent containing copper chloride, iron chloride, and the like may be used.

In the semi-additive process, the metal layer (B) is formed after formation of the primer resin layer (X), and organic compounds including a dispersant present in the metal layer (B) are removed, as needed, by a plasma discharge treatment or the like. Then, a plating resist layer having a shape corresponding to a desired pattern is formed on the surface of the resulting metal layer (B), and then, the metal-plating layer (C) is formed by an electroplating process or an electroless plating process. Subsequently, the plating resist layer and the metal layer (B) in contact therewith are removed by dissolution with a chemical agent, whereby a desired pattern is formed.

The process of applying plating on a printing pattern of the metal layer (B) is performed as follows. A pattern of the metal layer (B) is printed after formation of the primer resin layer (X) by an inkjet process, a reverse printing process, or the like. Organic compounds including a dispersant present in the metal layer (B) are removed, as needed, by a plasma discharge treatment or the like, and then the metal-plating layer (C) is formed on the surface of the resulting metal layer (B) by an electroplating process or an electroless plating process, whereby the desired pattern is formed.

The electroconductive patterns obtained in the processes are excellent in the adhesiveness of the polyphenylene sulfide as a support of an electroconductive pattern with the metal-plating layer formed thereon even in a state where a voltage is applied in a high-temperature environment. Accordingly, the electroconductive patterns can be used, for example, for peripheral wirings and an electromagnetic shield that constitute a board for forming a circuit, such as an electronic circuit and an integrated circuit, an organic solar cell, an electronic terminal, an organic EL device, an organic transistor, a flexible printed wiring board, and an RFID. In addition, the electroconductive pattern can be used, for example, for an optical pickup for Blu-ray, DVD, and the like; an electrical member, an electric motor-related member, and a battery member for hybrid or electric vehicles; and an electromagnetic shield used in various electronic devices. Furthermore, the electroconductive pattern whose support is a film-like polyphenylene sulfide can be used, for example, for formation of layers or peripheral wirings constituting a flexible printed wiring board, an RFID, such as a non-contact IC card, and a film capacitor.

### Examples

The present invention will be described in detail below with reference to Examples. However, "Examples" 1, 5 and 6 are not according to the invention.

### [Production Example 1: production of resin composition (X-1) for primer resin layer]

In a container equipped with a thermometer, a nitrogen gas introduction tube, and a stirrer and purged with nitrogen, 100 parts by mass of polyester polyol (polyester polyol produced by allowing 1,4-cyclohexane dimethanol, neopentyl glycol, and adipic acid to react with each other), 17.6 parts by mass of 2,2-dimethylolpropionic acid, 21.7 parts by mass of 1,4-cyclohexanedimethanol, and 106.2 parts by mass of dicyclohexylmethane-4,4'-diisocyanate were allowed to react in a mixed solvent of 178 parts by mass of methyl ethyl ketone, thereby producing a urethane prepolymer solution having an isocyanate group at an end thereof.

Subsequently, 13.3 parts by mass of triethylamine was added to the urethane prepolymer solution to thereby neutralize carboxyl groups in the urethane prepolymer, and 380 parts by mass of water was further added thereto, followed by thorough stirring, thereby producing an aqueous dispersion of the urethane prepolymer.

Into the resulting aqueous dispersion of the urethane prepolymer, 8.8 parts by mass of a 25 mass% ethylenediamine aqueous solution was added, followed by stirring to thereby extend the chain of the urethane prepolymer. Subsequently, through aging and solvent removal, an aqueous dispersion of a urethane resin (nonvolatile content: 30% by mass) was produced. The urethane resin has a weight average molecular weight of 53,000.

Subsequently, in a reaction vessel equipped with a stirrer, a reflux condenser, a nitrogen introduction tube, a thermometer, a dropping funnel for addition of a monomer mixture, and a dropping funnel for addition of polymerization catalyst, 140 parts by mass of deionized water was placed, and then 100 parts by mass of an aqueous dispersion of the urethane resin obtained above was placed. The mixture was heated to 80°C under nitrogen blowing. After that, under stirring, a monomer mixture containing 60 parts by mass of methyl methacrylate, 30 parts by mass of n-butyl acrylate, and 10 parts by mass of N-n-butoxymethyl acrylamide, and 20 parts by mass of a 0.5 mass% ammonium persulfate aqueous solution were added dropwise from different dropping funnels over 120 minutes while keeping a temperature in the reaction vessel at 80°C.

After completion of the dropwise addition, stirring was further continued at the same temperature for 60 minutes, and then, the temperature in the reaction vessel was lowered to 40°C. After diluted with deionized water so as to give a nonvolatile content of 20% by mass, the reaction mixture was filtered through a 200 mesh filter cloth, thereby producing an aqueous dispersion of a resin composition (X-1) for primer resin layer which was a core-shell-type composite resin having the urethane resin as a shell layer and a vinyl resin whose raw material was methyl methacrylate as a core layer.

### [Production Example 2: production of resin composition (X-2) for primer resin layer]

In a reaction flask equipped with a reflux condenser, a thermometer, and a stirrer, 200 parts by mass of water and 350 parts by mass of methanol were added to 600 parts by mass of a formalin containing 37 mass% formaldehyde and 7 mass% methanol. Subsequently, into the aqueous solution, a 25 mass% sodium hydroxide aqueous solution was added to adjust the pH to 10, and then 310 parts by mass of melamine was added, and the liquid temperature was increased to 85°C to effect a methylolizing reaction for 1 hour.

After that, formic acid was added thereto to adjust the pH to 7, followed by cooling to 60°C, thereby effecting an etherification reaction (secondary reaction). A 25 mass% sodium hydroxide aqueous solution was added at a cloud temperature of 40°C to adjust the pH to 9, thereby quenching the etherification reaction (reaction time: 1 hour). Remaining methanol was removed at a temperature of 50°C under a reduced pressure (time for methanol removal: 4 hours), thereby producing a resin composition (X-2) for primer resin layer containing a melamine resin having a nonvolatile content of 80%.

### [Production Example 3: production of resin composition (X-3) for primer resin layer]

In a reaction vessel equipped with a thermometer, a nitrogen gas introduction tube, and a stirrer and purged with nitrogen, 9.2 parts by mass of 2,2-dimethylolpropionic acid, 57.4 parts by mass of polymethylene polyphenyl polyisocyanate ("Millionate MR-200" from TOSOH CORPORATION"), and 233 parts by mass of methyl ethyl ketone were placed, and allowed to react at 70°C for 6 hours, thereby producing an isocyanate compound. Subsequently, into the reaction vessel, 26.4 parts by mass of phenol was supplied as a blocking agent, and the resultant was allowed to react at 70°C for 6 hours. After that, the reaction mixture was cooled to 40°C, thereby producing a solution of block isocyanate.

Subsequently, into the resulting solution of the block isocyanate, 7 parts by mass of triethyl amine was added at 40°C to thereby neutralize carboxyl groups in the block isocyanate. Water was added, followed by thorough stirring, and then methyl ethyl ketone was removed by distillation, thereby producing a resin composition (X-3) for primer resin layer containing the block isocyanate and water having a nonvolatile content of 20% by mass.

### [Preparation Example 1: preparation of fluid (1)]

Silver particles having an average particle size of 30 nm were dispersed in a mixed solvent of 45 parts by mass of ethylene glycol and 55 parts by mass of ion exchange water with a compound of polyethyleneimine having polyoxyethylene added thereto used as a dispersant, thereby preparing a fluid containing a nanosized metal powder and a dispersant. Subsequently, ion exchange water and a surfactant were added to the resulting fluid to adjust the viscosity to 10 mPa·s, thereby preparing a fluid (1) which is a conductive ink for inkjet printing.

### [Example 1] (not according to the invention)

100 parts by mass of a linear polyphenylene sulfide (MFR by ASTM D1238-86: 600 g/10 minutes), 54.5 parts by mass of a chopped glass fiber ("FT562" from Asahi Fiber Glass Co. Ltd., fibrous inorganic filler), 0.5 parts by mass of a glycidyl methacrylate-modified ethylene-methyl acrylate copolymer elastomer ("BONDFAST 7L" from Sumitomo Chemical Co., Ltd.), and 0.8 parts by mass of a montanic composite ester wax ("Licolub WE40" from Clariant Japan KK) were uniformly mixed, and the mixture was then melt-kneaded in a twin-screw extruder of 35 mmϕ at 290 to 330°C, thereby producing a polyphenylene sulfide resin composition. The resulting polyphenylene sulfide resin composition was molded in an injection molding machine, thereby producing a support (A-1) having a size of 50 mm × 105 mm × 2 mm.

The aqueous dispersion of the resin composition (X-1) for primer resin layer produced in Production Example 1 was applied on a surface of the support (A-1) obtained above with a spin coater so as to give a dry film thickness of 0.1 µm, and then, dried with a hot air dryer at 80°C for 5 minutes, whereby a primer resin layer was formed on the support (A-1).

Subsequently, on the entire surface of the primer resin layer, the fluid (1) produced in Preparation Example 1 was applied with an inkjet printer ("Inkjet Tester EB100" from Konica Minolta Inc., printer head for evaluation: KM512L, ejection amount: 42 pL). Then, through sintering at 200°C for 30 minutes, a silver layer (thickness: about 0.1 µm) corresponding to the metal layer (B) was formed.

Next, the surface of the resulting silver layer was set as a cathode and a phosphorus-containing copper was set as an anode, and using an electroplating liquid containing copper sulfate, electroplating was performed at a current density of 2.5 A/dm² for 40 minutes, whereby a copper-plating layer having a thickness of 15 µm was laminated on the surface of the silver layer. As the electroplating liquid, 70 g/L of copper sulfate, 200 g/L of sulfuric acid, 50 mg/L of chloride ions, and 5 g/L of Top Lucina SF (a gloss agent from Okuno Chemical Industries Co., Ltd.) were used.

According to the above process, a laminated body (1) including the support (A), the primer resin layer (X), the metal layer (B), and the metal-plating layer (C) laminated in this order was produced.

### [Examples 2 to 4]

Laminated bodies (2) to (5) each including the support (A), the primer resin layer (X), the metal layer (B), and the metal-plating layer (C) laminated in this order were produced in the same manner as in Example 1, except that the polyphenylene sulfide resin composition used for the support was changed to have the respective compositions shown in Table 1 to produce supports (A-2) to (A-5), respectively, and that the resin composition (X-1) for primer resin layer was changed to the resin composition (X-2) for primer resin layer.

### [Example 5] (not according to the invention)

A laminated body (5) including the support (A), the primer resin layer (X), the metal layer (B), and the metal-plating layer (C) laminated in this order was produced in the same manner as in Example 1, except that the polyphenylene sulfide resin composition used for the support was changed to have a composition shown in Table 1 to produce a support (A-5), and that the resin composition (X-1) for primer resin layer was changed to the resin composition (X-3) for primer resin layer.

### [Example 6] (not according to the invention)

A laminated body (6) including the support (A), the metal layer (B), and the metal-plating layer (C) laminated in this order was produced in the same manner as in Example 1, except that the support (A-3) produced in Example 3 was used to form a silver layer directly on the support (A-3) without the resin composition (X-1) for primer resin layer.

### [Comparative Example 1]

A laminated body (R1) including the support (A), the primer resin layer (X), the metal layer (B), and the metal-plating layer (C) laminated in this order was produced in the same manner as in Example 1, except that the polyphenylene sulfide resin composition used for the support was changed to have a composition shown in Table 1 to produce support (A-6), and that the resin composition (X-1) for primer resin layer was changed to the resin composition (X-2) for primer resin layer.

### [Comparative Example 2]

A laminated body (R2) including the support (A), the metal layer (B), and the metal-plating layer (C) laminated in this order was produced in the same manner as in Example 1, except that the polyphenylene sulfide resin composition used for the support was changed to have a composition shown in Table 1 to produce a support (A-7), and that a silver layer was formed directly on the support (A-3) without the resin composition (X-1) for primer resin layer.

The laminated bodies (1) to (6) and (R1) and (R2) obtained in Examples 1 to 6 and Comparative Examples 1 and 2 were each measured and evaluated for the peeling strengths before and after heating in the following manner.

### <Measurement of peeling strength before heating>

Each laminated body obtained above was measured for peeling strength using "Autograph AGS-X 500N" from Shimadzu Corporation. Incidentally, the lead width for measurement was 5 mm and the peeling angle was 90°. The peeling strength tends to have higher values as the thickness of the metal-plating layer increases, and the measurement of the peeling strength in the present invention was performed on the basis of the measurement value at a metal-plating layer thickness of 15 µm.

### <Measurement of peeling test after heating>

Each laminated body obtained above was heated through storage in a dryer set at 150°C for 168 hours. After the heating, peeling strength was measured in the same manner as the above.

### <Evaluation of thermal resistance>

Using the peeling strength values before and after heating determined above, the retention rate thereof from before to after heating was calculated and the thermal resistance was evaluated by the following criteria.
A: The retention rate is 80% or more.
B: The retention rate is 70% or more and less than 80%.
C: The retention rate is 50% or more and less than 70%.
D: The retention rate is less than 50%.

Table 1 shows the compositions of the polyphenylene sulfide resin compositions constituting the supports used in Examples 1 to 6 and Comparative Examples 1 and 2, the measurement results of the peeling strengths before and after heating, and the evaluation results of the thermal resistance.

**[Table 1]**

| Table 1 | | | Example 1* | Example 2 | Example 3 | Example 4 | Example 5* | Example 6* | Comparative Example 1 | Comparative Example 2 |
|---|---|---|---|---|---|---|---|---|---|---|
| Laminated body | | | (1) | (2) | (3) | (4) | (5) | (6) | (R1) | (R2) |
| Support | | | A-1 | A-2 | A-3 | A-4 | A-5 | A-3 | A-6 | A-7 |
| Composition of support (parts by mass) | Polyphenylene sulfide (a1) | | 100 | 100 | 100 | 100 | 100 | 100 | 100 | 100 |
| | Elastomer (a2) | | 0.5 | 3.2 | 8.4 | 18.3 | 87.0 | 8.4 | 0.0 | 344.8 |
| | Glass fiber (a3) | | 54.5 | 56.0 | 58.8 | 64.2 | 101.4 | 58.8 | 54.3 | 241.4 |
| | Montanic composite ester wax (a4) | | 0.8 | 0.8 | 0.8 | 0.9 | 1.4 | 0.8 | 0.8 | 3.4 |
| Primer layer | | | X-1 | X-2 | X-2 | X-2 | X-3 | None | X-2 | None |
| Evaluation result | Peeling strength of laminated body (N/m) | before heating | 420 | 480 | 700 | 640 | 645 | 500 | 50 | 200 |
| | | after heating | 330 | 400 | 620 | 580 | 500 | 420 | 10 | 10 |
| | Peeling strength retention rate (%) | | 78.6 | 83.3 | 88.6 | 90.6 | 77.5 | 84.0 | 20.0 | 5.0 |
| | Thermal resistance | | B | A | A | A | B | A | D | D |

| | | | | | | | | | | |
|---|---|---|---|---|---|---|---|---|---|---|
| *not according to the invention | | | | | | | | | | |

It could be confirmed from the results shown in Table 1 that the laminated bodies (1) to (6) obtained in Examples 1 to 6, had high peeling strengths, showed small reductions in the peeling strength after heating, and also had high retention rates of the peeling strength after heating, thus having excellent thermal resistance.

On the other hand, it could be confirmed that the laminated body (R1) obtained in Comparative Example 1, which was an example in which the polyphenylene sulfide resin composition constituting the support did not contain the elastomer, which is an essential component of the present invention, had a significantly low peeling strength in both before and after heating.

It could also be confirmed that the laminated body (R2) obtained in Comparative Example 2, which was an example in which the polyphenylene sulfide resin composition constituting the support contained the elastomer of the present invention in an amount exceeding the upper limit of the invention, showed a significant reduction in the peeling strength after heating, in spite of relatively high peeling strength before heating.

## Claims

1. A laminated body comprising:
a support (A) that includes a polyphenylene sulfide resin composition containing a polyphenylene sulfide (a1) and an elastomer (a2), and
a primer resin layer (X), a metal layer (B), and a metal-plating layer (C) that are laminated on the support (A) in this order,
a resin constituting the primer resin layer (X) being one or more resins selected from the group consisting of a core-shell-type composite resin containing a urethane resin as a shell and a vinyl resin obtained by polymerizing a monomer including N-alkylol (meth)acrylamide as a core, a melamine resin, and a phenol block isocyanate,
**characterized in that** the elastomer (a2) is contained in the polyphenylene sulfide resin composition in an amount in the range of 2 to 20 parts by mass relative to 100 parts by mass of the polyphenylene sulfide (a1).

2. The laminated body according to claim 1, wherein the elastomer is an olefin copolymer-based elastomer.

3. The laminated body according to claim 1 or 2, wherein a metal constituting the metal layer (B) is at least one selected from the group consisting of palladium, nickel, chromium, and silver.

4. The laminated body according to any one of claims 1 to 3, wherein the attached amount of the metal layer (B) is in the range of 1 to 30,000 mg/m².

5. The laminated body according to any one of claims 1 to 4, wherein the metal-plating layer (C) is formed by an electroplating process, an electroless plating process, or a combination thereof.

6. A molded article comprising a laminated body as set forth in any one of claims 1 to 5.

7. An electroconductive pattern comprising a laminated body as set forth in any one of claims 1 to 5.

8. An electronic circuit comprising an electroconductive pattern as set forth in claim 7.

9. An electromagnetic shield comprising the laminated body as set forth in any one of claims 1 to 5.

## Patentansprüche

1. Laminierter Körper, umfassend:
einen Träger (A), enthaltend eine Polyphenylensulfidharzzusammensetzung, enthaltend ein Polyphenylensulfid (a1) und ein Elastomer (a2), und
eine Primer-Harzschicht (X), eine Metallschicht (B) und eine Metallüberzugsschicht (C), die auf dem Träger (A) in dieser Reihenfolge auflaminiert sind,
wobei ein Harz, das die Primer-Harzschicht (X) bildet, ein oder mehr Harze ist, ausgewählt aus der Gruppe bestehend aus einem Verbundharz vom Kern-Schale-Typ, enthaltend ein Urethanharz als Schale und ein Vinylharz, erhalten durch Polymerisieren eines Monomers, enthaltend N-Alkylol(meth)acrylamid, als Kern, einem Melaminharz und einem Phenol-Block-Isocyanat,
**dadurch gekennzeichnet, dass** das Elastomer (a2) in der Polyphenylensulfidharzzusammensetzung enthalten ist in einer Menge im Bereich von 2 bis 20 Masseteile, bezogen auf 100 Masseteile des Polyphenylensulfids (a1).

2. Laminierter Körper nach Anspruch 1, wobei das Elastomer ein Elastomer auf Olefin-Copolymer-Basis ist.

3. Laminierter Körper nach Anspruch 1 oder 2, wobei ein Metall, das die Metallschicht (B) bildet, mindestens eines ist, ausgewählt aus der Gruppe bestehend aus Palladium, Nickel, Chrom und Silber.

4. Laminierter Körper nach einem der Ansprüche 1 bis 3, wobei die aufgebrachte Menge der Metallschicht (B) im Bereich von 1 bis 30.000 mg/m² liegt.

5. Laminierter Körper nach einem der Ansprüche 1 bis 4, wobei die Metallüberzugsschicht (C) gebildet ist durch einen galvanischen Prozess, einen stromlosen Beschichtungsprozess oder eine Kombination davon.

6. Geformter Gegenstand, umfassend einen laminierten Körper gemäß einem der Ansprüche 1 bis 5.

7. Stromleitendes Muster, umfassend einen laminierten Körper gemäß einem der Ansprüche 1 bis 5.

8. Elektronische Schaltung, umfassend ein stromleitendes Muster gemäß Anspruch 7.

9. Elektromagnetische Abschirmung, umfassend den laminierten Körper gemäß einem der Ansprüche 1 bis 5.

## Revendications

1. Corps stratifié comprenant :
un support (A) qui comporte une composition de résine de polysulfure de phénylène contenant un polysulfure de phénylène (a1) et un élastomère (a2), et
une couche de résine d'amorçage (X), une couche métallique (B) et une couche de placage métallique (C) qui sont stratifiées sur le support (A) dans cet ordre,
une résine constituant la couche de résine d'amorçage (X) étant une ou plusieurs résines choisies dans le groupe constitué d'une résine composite de type noyau-enveloppe contenant une résine uréthane en tant qu'enveloppe et une résine vinylique obtenue en polymérisant un monomère comportant du N-alkylol (méth)acrylamide en tant que noyau, une résine mélamine et un isocyanate séquencé de phénol,
**caractérisé en ce que** l'élastomère (a2) est contenu dans la composition de résine de polysulfure de phénylène en une quantité étant comprise dans la plage allant de 2 à 20 parties en masse par rapport à 100 parties en masse du sulfure de polyphénylène (a1).

2. Corps stratifié selon la revendication 1, l'élastomère étant un élastomère à base de copolymère d'oléfine.

3. Corps stratifié selon la revendication 1 ou 2, un métal constituant la couche métallique (B) est au moins un métal choisi dans le groupe constitué de palladium, de nickel, de chrome et d'argent.

4. Corps stratifié selon l'une quelconque des revendications 1 à 3, la quantité fixée de la couche métallique (B) étant comprise dans la plage allant de 1 à 30 000 mg/m².

5. Corps stratifié selon l'une quelconque des revendications 1 à 4, la couche de placage métallique (C) étant formée par un processus d'électrodéposition, un processus de dépôt autocatalytique, ou une combinaison de ceux-ci.

6. Article moulé comprenant un corps stratifié selon l'une quelconque des revendications 1 à 5.

7. Motif électroconducteur comprenant un corps stratifié selon l'une quelconque des revendications 1 à 5.

8. Circuit électronique comprenant un motif électroconducteur selon la revendication 7.

9. Blindage électromagnétique comprenant le corps stratifié selon l'une quelconque des revendications 1 à 5.
